Europäisches Patentamt

European Patent Office

Office européen des brevets

(19)

(11) Publication number: 0 399 676
A1

# EUROPEAN PATENT APPLICATION

(21) Application number: 90304724.9

(22) Date of filing: 01.05.90

(51) Int. Cl.5: **H01L 21/311, C23C 14/54, H01L 21/00**

(30) Priority: 01.05.89 US 345796

(43) Date of publication of application:
28.11.90 Bulletin 90/48

(84) Designated Contracting States:
DE FR GB

(71) Applicant: TEGAL CORPORATION
2201 South McDowell Boulevard
Petaluma California 94953(US)

(72) Inventor: Lachenbruch, Roger Bennett
495 Sausalito Boulevard
Sausalito, California 94965(US)
Inventor: Giffen, Leslie
8238 Windmill Farms Drive
Cotati, California 94928(US)

(74) Representative: Dunlop, Hugh Christopher et
al
Motorola European Intellectual Property
Operations Jays Close Viables Industrial
Estate
Basingstoke, Hampshire RG22 4PD(GB)

(54) Dual temperature plasma etch.

(57) A tapered profile is obtained in a plasma glow discharge by varying the temperature of the wafer during the etch. The etch is isotropic while the wafer is hot and is anisotropic when the wafer is cool. The temperature is varied by valves (23-26) which switch temperature controlled fluids through the electrode (13) upon which the wafer (15) rests. By-pass conduits (41, 42) maintain the temperature of the plumbing by enabling continuous fluid flow so that the temperature of the electrode, and of the plumbing connecting it to the valves, stabilizes more rapidly.

Fig. 1

EP 0 399 676 A1

## DUAL TEMPERATURE PLASMA ETCH

### Background of the Invention

This invention relates to plasma etch processes for the manufacture of semiconductor wafers and, in general, to chemical (isotropic) etching followed by reactive ion etching or, in particular, to etching sloped vias in dielectric layers.

In the prior art, a number of applications require one to be able to switch from an isotropic etch to an anisotropic etch, or vice-versa. One such application is in etching access holes, vias, in dielectric layers to connect conductive layers at different levels or to open contact areas to devices formed on a wafer. The vias preferably have a tapered edge to facilitate deposition of a continuous conductor over the dielectric. In U.S. patent 4, 661, 204, it is disclosed that one can taper an etch in polyimide by first etching at high power, then at low power. Etching at high power reduces selectivity, causing the photoresist to erode, tapering the edge. Another technique is to perform a multi-step, repetitive switching of chemistries to etch the dielectric slightly, then the overlying photoresist, then the dielectric, then the photoresist, etc. The result is a stairstep profile which approximates the desired taper. As might be expected, reproducibility becomes a significant problem as is dimensional control. A similar technique, described in U.S. Patent 4, 764, 245, varies the composition of the gas mixture to change the selectivity of the etch to achieve a similar result. In none of these techniques is the isotropy of the etch changed.

It is an object of the present invention to provide an improved plasma etch process and apparatus.

Accordingly, the present invention provides a method in accordance with independent claims 1 and 5 and apparatus in accordance with claim 8.

In accordance with one aspect, the present invention provides an improved process for forming vias having sloped sidewalls.

In accordance with another aspect, the present invention enhances throughout by performing two different types of etch in the same reactor.

In accordance with another aspect, the present invention performs different types of etch, requiring different temperatures, in a single reactor.

In at least the preferred embodiment of the invention, an improved plasma etch process achieved is by varying the etch from isotropic to anisotropic during the etch by changing the temperature of the wafer during the etch cycle. By varying the isotropy of the etch, a non-vertical sidewall is obtained. The electrode on which the wafer rests is temperature controlled by fluid flowing therein. Stabilization time is minimized by locating the selection valves which control the fluid as close to the reactor as possible and by using by-pass connections so that supply conduits to the valves are maintained at operating temperature even if the particular fluid is not being used for temperature control.

In the related invention identified in US Patent 4,764,245, the power applied to a tri-electrode reactor is switched between the wafer electrode an a side electrode to effect a switch from isotropic to anisotropic etch. The present invention is compatible with this technique, i.e. it can be used in addition to this technique to enhance the etch rate in isotropic etching.

### Brief Description of the Drawings

A more complete understanding of the present invention can be obtained by considering the following detailed description in conjunction with the accompanying drawings, in which:

FIG. 1 illustrates a preferred embodiment of apparatus for carrying out the method of the present invention.

FIG. 2 illustrates the valve position for a low temperature wafer electrode.

FIG. 3 illustrates the valve position when neither fluid is supplied to the wafer electrode.

### Detailed Description of the Invention

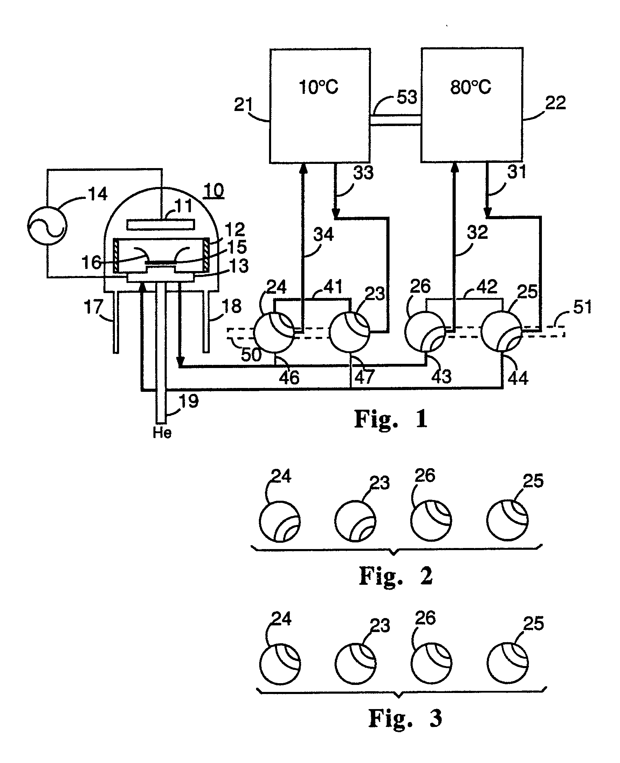

FIG. 1 illustrates a preferred embodiment of apparatus for carrying out the present invention. While such apparatus preferably comprises what is known as a tri-electrode reactor, the present invention can also be accomplished in what is known as a diode reactor. In addition, while described in connection with water cooling, it is understood by those of skill in the art that a variety of fluids can be used, as determined by the particular temperatures desired; e.g. water, alcohol, liquid nitrogen. Also, "water" is intended to include various mixtures such as, but not limited to, water and ethylene glycol. "Ambient temperature" refers to room temperature, 20° C.

In FIG. 1, plasma reactor 10 comprises an enclosure containing upper electrode 11, side electrode 12 and lower electrode 13. Connected to upper electrode 11 and lower electrode 13 is source 14 of RF power. Upper electrode 11 is preferably grounded. The plasma generated between electrodes 11 and 13 etches portions of wafer 15. Wafer 15 is held against lower electrode 13 by way of a plurality of tines 16, which are disposed more or less regularly around the periphery of wafer 15 and hold it in place. A suitable etch gas is supplied by way of port 17 and exhausted by way of port 18. Port 19 connects an external source of helium gas to the underside of wafer l5 through one or more channels, not shown, in the upper surface of electrode 13. As known per se in the art, this provides better thermal coupling between wafer 15 and electrode 13.

In a typical etch process, a wafer is positioned as shown, power is applied from source 14 and the wafer is exposed to the plasma discharge. The process tends to heat the wafer, raising its temperature. This change in temperature changes the efficacy of the etch, causing nonuniformities. It has been known in the art to use fluid cooling of electrode 13 to obviate these non-uniformities. A cooling fluid, typically water or antifreeze, is coupled through passageways in electrode 13. These passageways are separate from the passageways conveying helium from port 19.

While it has been known in the art to control the wafer temperature in this manner, it is not known in the art to provide isotropic and anisotropic etching of thin films, e.g. oxide, in the same chamber. This is obtained in apparatus in accordance with the present invention, enabling one to perform either etch with the same apparatus and, in addition, to produce a sloped sidewall in oxide.

In accordance with the preferred implementation of the present invention, reservoir 21 comprises water or other coolant at a suitable temperature, e.g. 10 $^\circ$ C. Reservoir 22 contains water at a different temperature, e.g. 80 $^\circ$ C. In the case of oxide etch, maintaining the wafer temperature either above or below ambient enhances isotropic and anisotropic etches, respectively.

A problem remains in that changing the temperature of the wafer entails more than simply changing the temperature of the wafer. One must also change the temperature of lower electrode 13 and the plumbing connecting electrode 13 with the source of fluid. In accordance with the preferred implementation of the present invention, this is accomplished by locating valves 23-26 as closely as possible to electrode 13.

Valves 23-26 preferably comprise what are known as three way valves and interconnect the supply and drain conduits from reservoirs 21 and 22 to electrode 13. Suitable pumps for moving the fluid, well known per se, are not shown. Supply conduit 33 from reservoir 21 is connected as one input to valve 23. One output from valve 23 is connected through bypass 41 to valve 24. ("Input" and "output" are relative terms. The fluid can flow in either direction through the valve.) Valve 24 has an output thereof connected to drain conduit 34. As indicated in FIG. 1 by the heavier conduit, the fluid in reservoir 21 flows along this path, circulating through all of the plumbing and maintaining it at the temperature of the fluid in reservoir 21.

Reservoir 22 has supply conduit 31 connected as one input to valve 25. An output from valve 25 is connected through conduit 44 to wafer 13. Drain conduit 43 is connected from electrode 13 to valve 26. The output from valve 26 is connected through drain conduit 32 to reservoir 22. Thus, as indicated by the heavier lines, fluid above ambient temperature flows from reservoir 22 through the valves to electrode 13 and back again. Thus, conduits 43 and 44 as well as electrode 13 are at the temperature of the fluid in reservoir 22.

Like valves 23 and 24, valves 25 and 26 are interconnected by bypass 42. Like valves 25 and 26, valves 23 and 24 are connected to electrode 13. Specifically, taps 46 and 47 are connected to conduits 43 and 44, respectively. Valves and 23 and 24 are actuated together as indicated by shaft 50. Valves 25 and 26 are actuated together as indicated by shaft 51. While illustrated as a mechanical coupling, it is understood by those of skill in the art that these valves may be individually actuated electronically, but operate in pairs.

Reservoirs 21 and 22 are interconnected by siphon 53 to equalize the fluid levels. Siphon 53 can be eliminated or closed if different fluids are used in the two reservoirs. Siphon 53 facilitates maintenance of the system and does not interfere with the temperature difference of the two reservoirs since there is little or no flow through the siphon during normal operation. Siphon 53 should not be located too near supply conduits 31 and 33, however.

FIG 2 illustrates the alignment of the valves when the fluid from reservoir 21 is being used to control the temperature of electrode 13. At the time of switchover, only conduits 46, 47, 43 and 44 and lower electrode 13 have to change temperature. By reducing the mass of these means, the time for the temperature change is reduced. Conduits 33 and 34, and valves 23 and 24, are already temperature stabilized thereby reducing the time for the system to stabilize.

In FIG. 3, the position of the valves bypasses both reservoirs so that no fluid is provided to electrode 13, other than the small amount of residual fluid in the conduits to the electrode. This position is used for maintenance or when positive temperature control is not required. A drain port, not shown, is used to clear the conduits. In this valve position, fluid flows continuously through supply conduits 31-34, and by-passes 41 and 42, maintaining them at the temperatures of their respective reservoirs.

In accordance with the preferred implementation of the present invention, a tapered etch can be performed in oxide through a patterned photoresist layer by exposing the oxide to a plasma comprising $NF_3$ and helium. Using fluid from reservoir 22 one obtains an isotropic etch, etching both vertically into the wafer and laterally into the sidewall. At some predetermined time, valves 23-26 are actuated, reducing the temperature of the wafer to the temperature of the fluid in reservoir 21, and the etch becomes anisotropic, thereby increasing the depth of the aperture.

Depending upon the geometry of the particular aperture being formed, this cycle can be repeated or terminated after the first isotropic etch. By using wafer temperature control in this fashion, one avoid a phenomenon known as resist "popping", a phenomenon indicative of some chemical reaction which is temperature dependent and indicative of thermal stress between the wafer and the photoresist. In tests of the present invention on photoresist coated wafers, the wafers showed a significant improvement in resistance to popping.

As an example, the present invention was used on a model 1513e tri-electrode plasma reactor as sold by Tegal Corporation. The reactor was modified to include the equipment illustrated to the right of reactor 10 in FIG. 1. For an isotropic etch of oxide, a fluid temperature of 80° C was applied to the lower electrode, which was electrically floating. The side and top electrodes were connected to a source of RF power, with the top electrode grounded. Using a mixture of $NF_3$ and helium for the plasma produced an isotropic etch with good uniformity and etch rate. A reactive ion etch (RIE) of the oxide was obtained by switching to a fluid temperature of 10° C-40° C. In addition, the lower electrode was powered and the side electrode floated. The gas mixture comprised $SF_6$, $CHF_3$, and helium. The result was good selectivity to the photoresist with no popping.

As understood by those of skill in the art, the above example is a preferred implementation of the present invention for etching oxide. The gas mixture was changed to enhance the selectivity of the anisotropic (RIE) etch. One could use ($NF_3$) or ($CF_4$ and oxygen) for both etches with some sacrifice in performance. Similarly, one can use a diode reactor, except for etching oxide which, at present, cannot be isotropically etched in a diode reactor.

There is thus provided an improved etch system in which either isotropic or anisotropic etches can be obtained from the same piece of equipment. In addition, the production capacity of the apparatus is not seriously impaired by the time it takes the temperature of the wafer to stabilize at a new temperature.

Having thus described the invention, it will be apparent to those of skill in the art that various modifications can be made within the scope of the present invention. For example, while described in connection with controlling the temperature of the wafer electrode, the present invention can be applied to all or other electrodes as well. In addition, while described in a preferred embodiment as using temperatures above and below ambient, any two temperatures can be used.

## Claims

1. In a method for etching a layer on a semiconductor wafer (15) through a layer of patterned photoresist by subjecting the exposed layer to a plasma glow discharge to produce non-vertical sidewalls, the improvement comprising the step of: varying the temperature of the wafer during the etch to vary the isotropy of the etch, thereby producing said non-vertical sidewalls.

2. The method as set forth in claim 1 comprising as a first step in varying the temperature of the wafer: heating the wafer to a first temperature for an anisotropic etch.

3. The method as set forth in claim 2 comprising as a second step in varying the temperature of the wafer: cooling the wafer to a second temperature, below said first temperature, for an isotropic etch.

4. The method as set forth in claim 3 and further comprising the steps of: terminating the plasma glow discharge before said second step; and re-initiating the plasma glow discharge when the wafer has cooled to a temperature below ambient temperature.

5. In a method for etching an oxide layer on a semiconductor wafer through a layer of patterned photoresist by subjecting the oxide layer to a plasma glow discharge in a tri-electrode reactor, the improvement comprising the steps of: heating the wafer to a first temperature for an anisotropic etch while applying RF power to the side and upper electrodes of said reactor; and cooling the wafer to a second temperature, below said first temperature, for an isotropic etch while applying RF power to the top and bottom electrodes of said reactor.

6. The method as set forth in claim 5 and further including the steps of: after said heating step, subjecting said wafer to a plasma discharge in a gas mixture comprising $NF_3$

and helium; and

after said cooling step, subjecting said wafer to a plasma discharge in a mixture comprising $SF_6$, $CHF_3$, and helium.

7. The method as set forth in claim 7 and further comprising the step of:

terminating said plasma discharge before said cooling step.

8. In apparatus for etching a semiconductor wafer (15) in a plasma glow discharge having a reactor (10) for containing said wafer and reactive gases at reduce pressure, at least two electrodes (11, 13) through which RF power is coupled to cause said discharge, one (13) of said electrodes supporting said wafer and containing passageways for the flow of fluid through the electrode to control the temperature thereof, the improvement comprising:

first means (21) for supplying fluid at a first temperature;

second means (22) for supplying fluid at a second temperature;

valve means (23, 24, 25, 26) for selecting one or the other of said first and second means to supply fluid to said one electrode;

first conduit means (31, 32, 33, 34) connecting said first and second means to said valve means; and

second conduit means (43, 44) connecting said valve means to said one electrode.

9. The apparatus as set forth in claim 8 wherein said valve means is located outside said reactor and proximate said one electrode and wherein said second conduit means is relatively short in length, thereby reducing the stabilization time when fluids of different temperature are supplied to said one electrode.

10. The apparatus as set forth in claim 8 and further comprising:

by-pass means (41, 42) connected to said valve means for interconnecting the supply and drain sides of said valve means;

wherein said valve means comprises three-way valves for coupling fluid from said first or second means either to said one electrode or to said by-pass means whereby fluid flows continuously through said first conduit means.

**Fig. 1**

**Fig. 2**

**Fig. 3**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 301 355 (HITACHI) <br> * Figure 1; column 5, lines 17-29; claims 1-5 * | 1,4 | H 01 L 21/311 <br> C 23 C 14/54 <br> H 01 L 21/00 |
| Y | | 2,3 | |
| Y | US-A-4 484 978 (FAIRCHILD) <br> * Figure 1; claim 1 * | 2,3 | |
| A | SOLID STATE TECHNOLOGY, vol. 28, no. 4, April 1985, pages 251-255, Port Washington, New York, US; E. BOGLE-ROHWER et al.: "Wall profile control in a triode etcher" <br> * Figures 1,3; page 252, paragraph: "Oxide etching" * | 5 | |
| A | SOLID STATE TECHNOLOGY, vol. 31, no. 4, April 1988, pages 109-112, Port Washington, NY, US; G.O. FIOR et al.: "High-selectivity, silicon dioxide dry etching process" <br> * Page 110, left-hand column, paragraph 3 - page 111, left-hand column, paragraph 1 * | 6 | TECHNICAL FIELDS SEARCHED (Int. Cl.5) <br><br> H 01 L <br> C 23 C |
| A | EXTENDED ABSTRACTS, vol. 83, no. 2, 9th - 14th October 1983, pages 323-324, abstract no. 207, Washington, DC, US; B. GOLJA et al.: "Plasma etching characteristics of Si and SiO2 in NF3/Ar and NF3/He plasmas" <br> * Whole document * | 6 | |
| A | EP-A-0 297 898 (TOSHIBA) <br> * Abstract; figure 9 * <br> -/- | 1-10 | |

The present search report has been drawn up for all claims

| Place of search | Date of completion of the search | Examiner |
|---|---|---|
| THE HAGUE | 24-08-1990 | GORI P. |

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 369 989  (IBM) <br> * Figure 9 * <br> ----- | 8-10 | |

TECHNICAL FIELDS
SEARCHED (Int. Cl.5)

The present search report has been drawn up for all claims

| Place of search | Date of completion of the search | Examiner |
|---|---|---|
| THE HAGUE | 24-08-1990 | GORI P. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P0401)